# EUROPÄISCHE PATENTSCHRIFT

(11) **EP 3 827 646 B1**
(45) Veröffentlichungstag und Bekanntmachung des Hinweises auf die Patenterteilung: **29.04.2026**
(21) Anmeldenummer: 19745102.4
(22) Anmeldetag: 23.07.2019
(51) Int. Cl.: H05K 3/46, H05K 1/03, H05K 1/02

(54) **SUBSTRAT MIT INTEGRIERTEN ÜBERSPANNUNGSSCHUTZ**
SUBSTRATE WITH INTEGRATED OVERVOLTAGE PROTECTION
SUBSTRAT AVEC PROTECTION INTÉGRÉE CONTRE LES SURTENSIONS

(30) Priorität: 25.07.2018 DE 102018118016
(43) Veröffentlichungstag der Anmeldung: 02.06.2021
(73) Patentinhaber: TDK Electronics AG, 81671 München (DE)
(72) Erfinder: FEICHTINGER, Thomas, 8010 Graz (AT); TAUBER, Katharina, 8301 Lassnitzhöhe (AT); GEIER, Roman, 8053 Graz (AT)
(74) Vertreter: Epping - Hermann - Fischer
(86) Internationale Anmeldenummer: PCT/EP2019/069823
(87) Internationale Veröffentlichungsnummer: WO 2020/020900

(56) Entgegenhaltungen:
- DE-A1- 102006 000 935
- US-A- 5 396 034
- US-A1- 2005 263 867

## Beschreibung

Die vorliegende Erfindung betrifft ein Substrat, das einen keramischen Grundkörper umfasst.

Substrate sind weitverbreitete Komponenten in der industriellen Fertigung, um mikroelektronische Bauteile, wie integrierte Schaltkreise, und Leistungshalbleiter, wie LEDs darauf anzuordnen und zu kontaktieren. Die so verbauten mikroelektronischen Bauteile und Leistungshalbleiter können anschließend auf einfache Weise in weitere elektronische Bauteile integriert werden.

Beispiele für solche Substrate werden in der US 5396034 A oder der US 2005/263867 A1 offenbart.

Aufgrund stetig steigender Anforderungen bezüglich der Miniaturisierung und Leistungsfähigkeit der weiteren elektronischen Bauteile, ist es notwendig die Anzahl der mikroelektronischen Bauteile und Leistungshalbleiter, die auf einer gegebenen Fläche eines Substrats verbaut werden können, zu erhöhen. Daraus resultieren steigende Anforderungen an das Substrat bezüglich der Anzahl an Umverdrahtungen auf der gegebenen Fläche des Substrats und thermischen Leitfähigkeiten von Substratmaterialien. Insbesondere die thermische Leitfähigkeit des Substratmaterials ist ein wichtiger Faktor. Bei steigender Anzahl an mikroelektronischen Bauteilen und Leistungshalbleitern, die auf der gegebenen Fläche des Substrats verbaut werden müssen, muss die von den mikroelektronischen Bauteilen und Leistungshalbleitern erzeugte Wärme zunehmend effizienter abgeleitet werden, um ein Überhitzen der Bauteile zu verhindern.

Herkömmliche Substrate bestehen oft aus polymerbasierten Verbundmaterialien, die zwar eine ausreichend hohe Anzahl an Umverdrahtungen ermöglichen, aber eine sehr geringe Wärmeleitfähigkeit aufweisen. Dadurch ist die Anzahl an mikroelektronischen Bauteilen und Leistungshalbleiter, die, trotz der ausreichend hohen Anzahl an Umverdrahtungen, auf dem Substrat verbaut werden können begrenzt und eine weitere Miniaturisierung wird erschwert.

Als ausreichend hohe Anzahl an Umverdrahtungen wird hier und im Folgenden eine Anzahl an Umverdrahtungen bezeichnet, die es ermöglicht die Anzahl an mikroelektronischen Bauteilen und Leistungshalbleitern, die auf der gegeben Fläche des Substrats verbaut werden können, soweit zu erhöhen, dass eine Miniaturisierung und/oder Leistungssteigerung der weiteren Bauteile erreicht werden kann.

Um eine Verbesserung der thermischen Leitfähigkeit zu erreichen werden herkömmlicherweise Substrate verwendet, die metallische Einlagen aufweisen. Bauartbedingt erlauben solche Substrate im Bereich der metallischen Einlagen keine Durchkontaktierungen und Umverdrahtungen innerhalb des Substrats, was zu einer Verringerung der Anzahl an mikroelektronischen Bauteilen und Leistungshalbleitern, die auf der gegebenen Fläche des Substrats verbaut werden können, führt. Dadurch wird eine weitere Miniaturisierung erschwert. Des Weiteren ist die thermische Leitfähigkeit solcher Substrate auf 7 bis 8 W/m·K limitiert, was ebenfalls eine weitere Miniaturisierung und Leistungssteigerung erschwert.

Aufgabe der vorliegenden Erfindung ist daher das Bereitstellen eines Substrates, das eine thermische Leitfähigkeit größer als 8 W/m·K aufweist und es ermöglicht eine ausreichend hohe Anzahl an Umverdrahtungen bereitzustellen.

Diese Aufgaben werden erfindungsgemäß durch ein Substrat nach Anspruch 1 gelöst. Weitere Ausführungsformen des Substrates sind weiteren Ansprüchen zu entnehmen.

Erfindungsgemäß wird ein Substrat, das einen keramischen Grundkörper und eine organische Oberflächenstruktur an mindestens einer ersten Außenfläche des keramischen Grundkörpers aufweist, bereitgestellt. In die organische Oberflächenstruktur sind äußere Umverdrahtungen integriert. Die Kombination eines keramischen Grundkörpers mit einer organischen Oberflächenstruktur erlaubt es die Vorteile beider Materialen zu vereinen. So weist der keramische Grundkörper eine thermische Leitfähigkeit auf, die weitaus höher ist als die eines herkömmlichen polymerbasierten Substrates. Andererseits erlaubt die organische Oberflächenstruktur die Herstellung von äußeren Umverdrahtungen in ausreichend hoher Anzahl, was eine weitere Miniaturisierung und Steigerung der Leistungsfähigkeit ermöglicht.

Ferner kann die organische Oberflächenstruktur des erfindungsgemäßen Substrats eine Vielzahl von organischen Schichten aufweisen. Ein mehrschichtiger Aufbau der organischen Oberflächenstruktur ermöglicht es, im Vergleich zu einem einschichtigen Aufbau der organischen Oberflächenstruktur, die Anzahl der äußeren Umverdrahtungen auf einer gegebenen Fläche des erfindungsgemäßen Substrats weiter zu erhöhen. Dadurch lässt sich die Anzahl an verbauten mikroelektronischen Bauteilen und Leistungshalbleitern auf der gegebenen Fläche des erfindungsgemäßen Substrats weiter erhöhen, wodurch eine weitere Miniaturisierung ermöglicht wird. Des Weiteren lässt sich durch die höhere Anzahl an mikroelektronischen Bauteilen und Leistungshalbleitern, die auf der gegebenen Fläche des erfindungsgemäßen Substrats verbaut sind, auch die Leistungsfähigkeit von weiteren Bauteilen verbessern, die das erfindungsgemäße Substrat mit den darauf verbauten mikroelektronischen Bauteilen und Leistungshalbleitern umfassen. So kann beispielweise die Anzahl an LEDs in einem LED-Modul mit gegebener Fläche erhöht werden, wodurch die Eigenschaften des LED-Moduls verbessert werden können.

Des Weiteren können die organischen Schichten der organischen Oberflächenstruktur des erfindungsgemäßen Substrats jeweils unterschiedliche organische Materialien als Hauptbestandteil enthalten. Mit anderen Worten, jede organische Schicht kann eine andere Zusammensetzung aufweisen. Dadurch lassen sich Eigenschaften der organischen Schichten, wie thermische Ausdehnung, optische Absorption und Reflektion, so anpassen, dass sie den gewünschten Anforderungen entsprechen.

Insbesondere kann der Hauptbestandteil der organischen Oberflächenstruktur des erfindungsgemäßen Substrats, ausgewählt sein aus einer Gruppe, umfassend Fotolacke und gefüllte Polymere.

Ein gefülltes Polymer ist ein Polymer, das einen Füllstoff enthält, der die Eigenschaften des Polymers verbessert. In einer Ausführungsform des erfindungsgemäßen Substrats kann der Hauptbestandteil der organischen Oberflächenstruktur ein gefülltes Polymer umfassen, das mit Keramikpartikeln gefüllt ist, um seine thermische Leitfähigkeit zu erhöhen. Dadurch lassen sich die auf dem erfindungsgemäßen Substrat verbauten mikroelektronischen Bauteile und Leistungshalbleiter noch besser vor Überhitzung schützen.

Durch die Verwendung eines Fotolacks kann die organische Oberflächenstruktur des erfindungsgemäßen Substrats sehr einfach und präzise ausgebildet werden. Dadurch können Abstände zwischen einzelnen Umverdrahtungen so klein ausgebildet werden, dass eine weitere Miniaturisierung und/oder Leistungssteigerung ermöglicht wird.

Erfindungsgemäß ist auf der ersten Außenfläche des keramischen Grundkörpers des Substrats eine Passivierungsschicht aufgebracht. Auf dieser Passivierungsschicht ist die organische Oberflächenstruktur ausgebracht. Mit anderen Worten, die Passivierungsschicht befindet sich zwischen der ersten Außenfläche des keramischen Grundkörpers und der organischen Oberflächenstruktur. Die soeben beschriebene Anordnung der Passivierungsschicht und der organischen Oberflächenstruktur kann analog für mehr als eine Außenfläche des keramischen Grundkörpers angewendet werden.

Die Passivierungsschicht schützt den keramischen Grundkörper vor möglicher Korrosion, die während der Herstellung der organischen Oberflächenstruktur, beispielsweise durch die verwendeten Lösungsmittel, auftreten kann. Die Passivierungsschicht enthaltet als Hauptbestandteil ein anorganisches Material, das ausgewählt ist aus einer Gruppe, umfassend SiO₂, SiN und AlN.

Ferner kann die organische Oberflächenstruktur des erfindungsgemäßen Substrats einen thermischen Ausdehnungskoeffizienten aufweisen, der dem des keramischen Grundkörpers entspricht. Die Abweichung des thermischen Ausdehnungskoeffizienten der organischen Oberflächenstruktur bezogen auf den thermischen Ausdehnungskoeffizienten des keramischen Grundkörpers beträgt maximal ± 1 ppm/K. Insbesondere kann die organische Oberflächenstruktur einen thermischen Ausdehnungskoeffizienten aufweisen, der in einem Bereich zwischen 2 ppm/K bis 12 ppm/K liegt. Durch die sehr ähnlichen thermischen Ausdehnungskoeffizienten der organischen Oberflächenstruktur und des keramischen Grundkörpers des erfindungsgemäßen Substrats werden Spannungen zwischen der organischen Oberflächenstruktur und dem keramischen Grundkörper während einer thermischen Belastung, zum Beispiel durch die abgegebene Wärme eines Leistungshalbleiters, weitestgehend vermieden. Daraus resultiert eine höhere Lebensdauer des erfindungsgemäßen Substrats.

Weiterhin kann der keramische Grundkörper des erfindungsgemäßen Substrats eine thermische Leitfähigkeit von mehr als 8 W/m·K aufweisen. In vorteilhafteren Ausführungsformen des erfindungsgemäßen Substrats kann der keramische Grundkörper eine thermische Leitfähigkeit von mehr als 20 W/m·K, insbesondere von mehr als 100 W/m·K aufweisen. Solch eine hohe thermische Leitfähigkeit ermöglicht es, die von den auf dem Substrat verbauten mikroelektronischen Bauteilen und Leistungshalbleitern erzeugte Wärme effizient abzuleiten. Dadurch wird eine Überhitzung der auf dem Träger verbauten Bauteile so gut wie ausgeschlossen, wodurch eine weitere Miniaturisierung und/oder Steigerung der Leistungsfähigkeit ermöglicht werden kann.

Um eine solch hohe thermische Leitfähigkeit des keramischen Grundkörpers des erfindungsgemäßen Substrats zu ermöglichen, kann der Hauptbestandteil des keramischen Grundkörpers ausgewählt sein aus einer Gruppe umfassend ZnO-Bi, ZnO-Pr, Al₂O₃ und AlN.

Ferner kann der keramische Grundkörper des erfindungsgemäßen Substrats als Hauptbestandteil eine thermisch leitfähige Funktionskeramik enthalten. Funktionskeramiken sind Keramiken, deren Eigenschaften für eine Anwendung auf einem technischen Gebiet hin optimiert wurden. So kann eine Funktionskeramik, beispielsweise eine elektrische Leitfähigkeit aufweisen, die mit steigender Temperatur ansteigt. Der keramische Grundkörper des erfindungsgemäßen Substrats kann als Hauptbestandteil eine Funktionskeramik aufweisen, die ausgewählt ist aus einer Gruppe, umfassend Keramiken mit negativen Temperaturkoeffizienten(NTC-Keramiken), positiven Temperaturkoeffizienten (PTC-Keramiken) und Varistorkeramiken.

Insbesondere die Verwendung einer Varistorkeramik ermöglicht es, einen Überspannungsschutz innerhalb des keramischen Grundkörpers des erfindungsgemäßen Substrates zu realisieren. So kann auf die Bereitstellung des Überspannungsschutzes mittels eines diskreten, auf dem Substrat zu montierenden Bauteils verzichtet werden. Dadurch kann das erfindungsgemäße Substrat mitsamt der auf ihm verbauten mikroelektronischen Bauteile und Leistungshalbleiter kompakter konstruiert werden.

Weiterhin kann der keramische Grundkörper des erfindungsgemäßen Substrats innere Umverdrahtungen und Vias aufweisen. Insbesondere das Vorhandensein von inneren Umverdrahtungen ermöglicht es, stark beanspruchte Leitungen, wie zum Beispiel Power-Leitungen zu den Leistungshalbleitern oder integrierten Schaltkreisen in den keramischen Grundkörper des erfindungsgemäßen Substrats zu integrieren. Da der keramische Grundkörper des erfindungsgemäßen Substrats eine höhere thermische Leitfähigkeit aufweist als herkömmliche polymerbasierte Substrate lässt sich die abgegebene Hitze solcher Leitungen noch effizienter ableiten und eine Überhitzung der auf dem erfindungsgemäßen Substrat verbauten mikroelektronischen Bauteile und Leistungshalbleiter kann wirksam verhindert werden.

Um die inneren Umverdrahtungen und den in den keramischen Grundkörper integrierten Überspannungsschutz zu realisieren, kann der keramische Grundkörper des erfindungsgemäßen Substrats eine Vielzahl von keramischen Schichten umfassen.

Ferner kann der keramische Grundkörper des erfindungsgemäßen Substrats ganz oder teilweise in eine organische Leiterplatte eingebettet sein. Insbesondere kann der Hauptbestandteil der organischen Leiterplatte beispielsweise einen Verbundwerkstoff aus Epoxidharz und Glasfasern umfassen.

Insbesondere kann der thermische Ausdehnungskoeffizient der organischen Leiterplatte an den thermischen Ausdehnungskoeffizienten des keramischen Grundkörpers angepasst sein, derart, dass der thermische Ausdehnungskoeffizient der Leiterplatte maximal ± 1ppm/K von dem thermischen Ausdehnungskoeffizienten des keramischen Grundkörpers abweicht. Dadurch lassen sich Spannungen, die durch thermische Belastungen, beispielsweise durch eine LED, zwischen dem erfindungsgemäßen Substrat und der organischen Leiterplatte entstehen weitgehend verhindern. Dadurch kann die Lebensdauer des erfindungsgemäßen Substrats, das in die organische Leiterplatte ganz oder teilweise eingebettet ist verlängert werden.

Ferner kann die organische Leiterplatte ebenfalls eine organische Oberflächenstruktur, äußere und innere Umverdrahtungen aufweisen. Der keramische Grundkörper des erfindungsgemäßen Substrats und die organische Leiterplatte können mittels inneren und äußeren Umverdrahtungen leitend miteinander verbunden sein.

Weiterhin kann das erfindungsgemäße Substrat und/oder die organische Leiterplatte äußere Umverdrahtungen, die aus einem ersten Metall, und innere Umverdrahtungen, die aus einem zweiten Metall bestehen, aufweisen, wobei sich das erste Metall von dem zweiten Metall unterscheidet. Das erste Metall und das zweite Metall können ausgewählt sein aus einer Gruppe von Metallen, umfassend Kupfer und Silber. Die Verwendung unterschiedlicher Metalle ermöglicht es, die Wärmeausdehnungskoeffizienten der inneren und äußeren Umverdrahtungen optimal an das Material anzupassen, in dem sie integriert sind. Dadurch werden mechanische Belastungen in dem erfindungsgemäßen Substrat verringert und die Lebensdauer des erfindungsgemäßen Substrats verbessert.

Die Herstellung des erfindungsgemäßen Substrats kann durch herkömmliche Verfahren erfolgen. Ein solches Verfahren kann beispielsweise die Teilschritte umfassen:
- Bereitstellen eines keramischen Grundkörpers,
- Aufbringen einer Passivierungsschicht auf einer ersten Außenfläche des keramischen Grundkörpers,
- Aufbringen einer ersten organischen Schicht auf die Passivierungsschicht, wobei Bereiche auf der Passivierungsschicht, die Teil äußerer Umverdrahtungen werden sollen, nicht beschichtet werden, oder wobei dort die Beschichtung entfernt wird,
- Aufbringen einer ersten Metallschicht auf die erste organische Schicht und die Bereiche der Passivierungsschicht, die Teil der äußeren Umverdrahtungen werden sollen,
- Aufbringen einer zweiten organischen Schicht auf die erste Metallschicht, wobei die Bereiche auf der Passivierungsschicht, die Teil der äußeren Umverdrahtungen werden sollen und Bereiche auf der ersten organischen Schicht, die ebenfalls Teil der äußeren Umverdrahtungen werden sollen nicht beschichtet werden,
- Aufbringen einer zweiten Metallschicht auf die Bereiche auf der Passivierungsschicht und der ersten organischen Schicht, die die äußeren Umverdrahtungen bilden sollen,
- Entfernen der zweiten organischen Schicht und der ersten Metallschicht um die äußeren Umverdrahtungen zu bilden, wobei die erste Metallschicht nur in den Bereichen entfernt wird, die nicht die äußeren Umverdrahtungen bilden. Ferner werden die Bereiche auf der Passivierungsschicht und der ersten organischen Schicht, die die äußeren Umverdrahtungen bilden, derart ausgebildet, dass ein elektrisch leitender Kontakt zwischen den jeweiligen Bereichen besteht.

Durch Wiederholung der eben aufgeführten Verfahrensschritte gelingt es, eine zweite Ebene oder weitere Ebenen mit strukturierten Metallisierungen für eine Umverdrahtung herzustellen.

Im Folgenden wird die Erfindung anhand von Ausführungsbeispielen und dazugehörigen Figuren näher beschrieben.
Figur 1 zeigt einen schematischen Querschnitt einer Ausführungsform des erfindungsgemäßen Substrates.
Figur 2 zeigt einen schematischen Querschnitt einer Ausführungsform des erfindungsgemäßen Substrats mit inneren Umverdrahtungen.
Figur 3 zeigt einen schematischen Querschnitt einer Ausführungsform des erfindungsgemäßen Substrats mit inneren Umverdrahtungen und integriertem Überspannungsschutz.
Figur 4 zeigt einen schematischen Querschnitt einer Ausführungsform des erfindungsgemäßen Substrats, wobei das erfindungsgemäße Substrat in einer organischen Leiterplatte eingebettet ist.

Gleiche Elemente, ähnliche oder augenscheinlich gleiche Elemente sind in den Figuren mit den gleichen Bezugszeichen versehen. Die Figuren und die Größenverhältnisse in den Figuren sind nicht maßstabsgetreu.

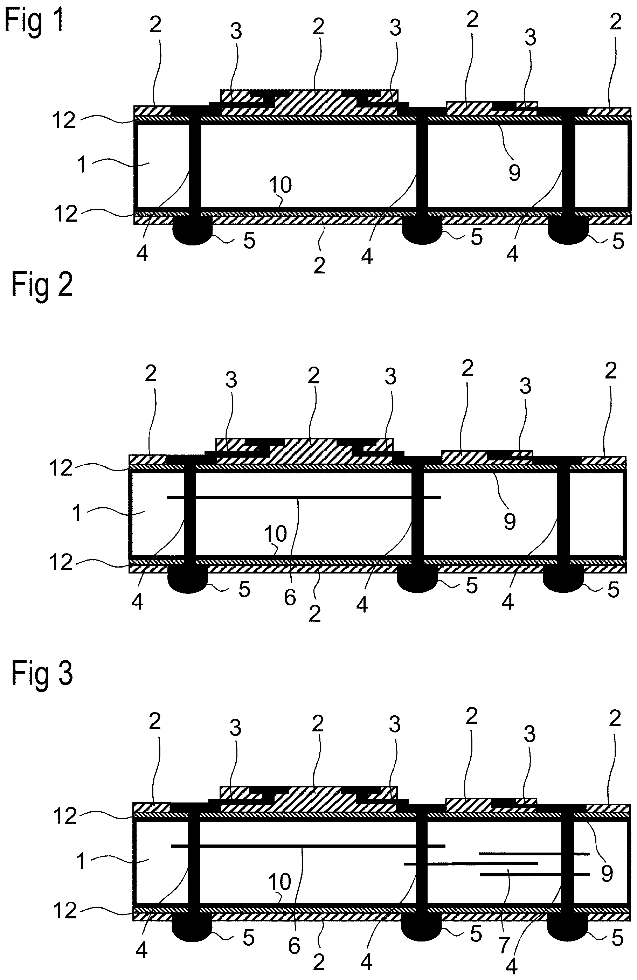

Figur 1 zeigt im schematischen Querschnitt eine Ausführungsform eines erfindungsgemäßen Substrats, aufweisend einen keramischen Grundkörper 1, eine Passivierungsschicht 12 auf einer ersten Außenfläche 9 und auf einer zweiten Außenfläche **10** des keramischen Grundkörpers **1.** Des Weiteren sind organische Oberflächenstrukturen **2** auf den Passivierungsschichten **12** ausgebildet. Die Passivierungsschichten **12** sind beispielsweise 100 nm dick und enthalten zum Beispiel SiN. Die Passivierungsschichten **12** schützen den keramischen Grundkörper **1** vor Korrosion, beispielsweise durch aggressive Lösungsmittel die während der Herstellung der organischen Oberflächenstruktur **2** eingesetzt werden. Ferner sind äußere Umverdrahtungen **3** in die organischen Oberflächenstrukturen **2** integriert. Aufgrund der organischen Oberflächenstrukturen **2** auf der ersten Außenfläche **9** und der zweiten Außenfläche **10** ist es möglich, die auf der ersten Außenfläche **9** verbauten mikroelektronischen Bauteile und Leistungshalbleiter (nicht abgebildet) über Vias **4** mittels Kontakten **5,** die auf der zweiten Außenfläche **10** ausgebildet sind, zu kontaktieren. Diese Art der Kontaktierung ermöglicht beispielsweise den Übergang von einer Kontaktierungsebene mit relativ großen Kontaktabständen zu einer Kontaktierungsebene mit relativ kleinen Kontaktabständen. Des Weiteren umfasst der keramische Grundkörper als Hauptbestandteil AlN, das eine thermische Leitfähigkeit von mehr als 100 W/m·K aufweist. Dies ermöglicht eine hocheffiziente Ableitung der Wärme, die durch auf dem Substrat verbaute mikroelektronische Bauteile und Leistungshalbleiter (nicht abgebildet) abgegeben wird. Dadurch wird eine Überhitzung selbiger effizient verhindert. In Kombination mit der organischen Oberflächenstruktur **2,** die eine ausreichend hohe Anzahl an äußeren Umverdrahtungen **3** ermöglicht, ist es möglich, Abstände zwischen auf dem Substrat verbauten Bauteilen zu verringern und somit eine weitere Miniaturisierung und Leistungssteigerung zu ermöglichen.

Figur 2 zeigt im schematischen Querschnitt eine weitere Ausführungsform eines Substrats. Zusätzlich zur Ausführung nach Figur 1 weist der keramische Grundkörper **1** innere Umverdrahtungen **6** auf. Durch die inneren Umverdrahtungen **6** ist es möglich, stark beanspruchte Leitungen in den keramischen Grundkörper **1,** der eine bessere thermische Leitfähigkeit aufweist als herkömmliche polymerbasierte Substrate, zu integrieren. Dies stellt einen weiteren Schutz der auf dem Substrat verbauten mikroelektronischen Bauteile und Leistungshalbleiter (nicht abgebildet) vor Überhitzung dar. Dadurch ist es möglich die Anzahl der auf dem Substrat verbauten mikroelektronischen Bauteile und Leistungshalbleiter auf einer gegebenen Fläche des Substrats zu erhöhen. Dadurch wird eine Überhitzung selbiger effektiv verhindert. Dies ermöglicht eine kompaktere Bauweise des Substrats.

Figur 3 zeigt im schematischen Querschnitt eine andere Ausführungsform eines Substrats. Zusätzlich zum in Figur 2 beschriebenen weist der keramische Grundkörper einen Überspannungsschutz **7** auf. Zu diesem Zweck umfasst der keramische Grundkörper **1** eine Varistorkeramik, deren Hauptbestandteil beispielsweise ZnO-Pr ist. Durch die Integration des Überspannungsschutzes **7** in den keramischen Grundkörper **1** kann auf die Ausbildung des Überspannungsschutzes **7** als diskretes Bauteil auf der äußeren Oberfläche des Substrats verzichtet werden. Dies schafft mehr Fläche für mikroelektronische Bauteile und Leistungshalbleiter die auf dem Substrat verbaut werden können.

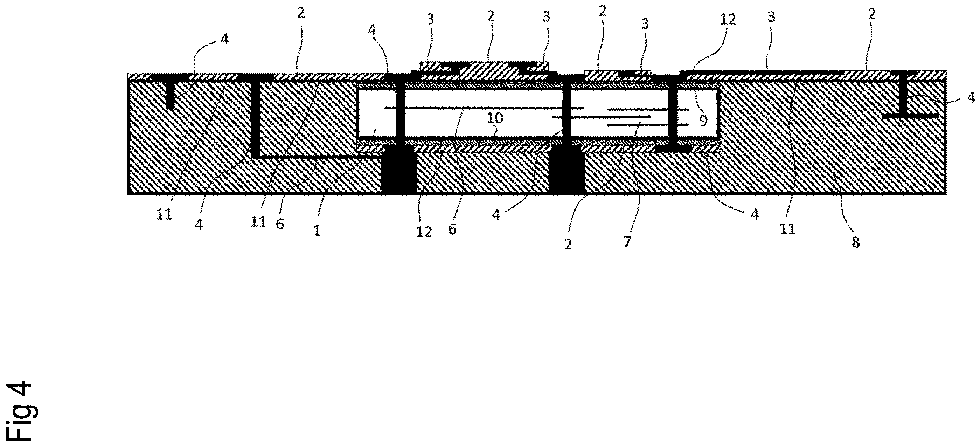

Figur 4 zeigt im schematischen Querschnitt eine Ausführungsform eines Substrats, welches ähnlich wie in Figur 3 ausgebildet sein kann, das aber in eine Aussparung einer Oberfläche **11** einer organischen Leiterplatte **8** eingebettet ist. Die Passivierungsschicht **12,** die auf der ersten Außenfläche **9** des keramischen Grundkörpers aufgebracht ist, schließt bündig mit der Oberfläche **11** der Leiterplatte **8** ab. Der Hauptbestandteil der organischen Leiterplatte **8** kann beispielsweise Glasfasern und Epoxidharz umfassen. Das Substrat, welches ähnlich dem in Figur 3 beschriebenen ist, und die organische Leiterplatte **8** weisen beide eine organische Oberflächenstruktur **2** mit integrierten äußeren Umverdrahtungen **3** auf. Das Substrat, welches ähnlich dem in Figur 3 beschriebenen ist, und die organische Leiterplatte **8** sind über innere Umverdrahtungen **6** und äußere Umverdrahtungen **3** leitend miteinander verbunden. Durch die Einbettung des Substrats in die organische Leiterplatte ist es insbesondere möglich, auf Standardgrößen für keramische Grundkörper **1** und für organische Leiterplatten **8** zurückzugreifen, was die Fertigung vereinfacht und dadurch die Kosten reduziert, da keine Sondergrößen, beispielsweise für den keramische Grundkörper **1,** angefertigt werden müssen.

### Bezugszeichenliste

- **1**: keramischer Grundkörper
- **2**: organische Oberflächenstruktur
- **3**: äußere Umverdrahtung
- **4**: Via
- **5**: Kontakt
- **6**: innere Umverdrahtung
- **7**: Überspannungsschutz
- **8**: organische Leiterplatte
- **9**: erste Außenfläche
- **10**: zweite Außenfläche
- **11**: Oberfläche der organischen Leiterplatte
- 12: Passivierungsschicht

## Patentansprüche

1. Substrat,
aufweisend einen keramischen Grundkörper (1) und eine organische Oberflächenstruktur (2) auf mindestens einer ersten Außenfläche (9) des keramischen Grundkörpers (1), wobei in die organische Oberflächenstruktur (2) äußere Umverdrahtungen (3) integriert sind und
wobei der keramische Grundkörper (1) einen integrierten Überspannungsschutz (7) aufweist,
wobei mindestens auf der ersten Außenfläche (9) des keramischen Grundkörpers (1) eine Passivierungsschicht (12) aufgebracht ist, wobei sich die Passivierungsschicht (12) zwischen der ersten Außenfläche (9) des keramischen Grundkörpers (1) und der organischen Oberflächenstruktur (2) befindet und als Hauptbestandteil ein anorganisches Material enthält, das ausgewählt ist aus einer Gruppe, umfassend, SiO₂, AlN und SiN.

2. Substrat nach Anspruch 1,
wobei die organische Oberflächenstruktur (2) eine Vielzahl von organischen Schichten umfasst.

3. Substrat nach einem der Ansprüche 1 oder 2,
wobei die organischen Schichten der organischen Oberflächenstruktur (2) jeweils unterschiedliche organische Materialien als Hauptbestandteil enthalten, die ausgewählt sind aus einer Gruppe, umfassend Fotolacke und gefüllte Polymere.

4. Substrat nach einem der Ansprüche 1 bis 3,
wobei der keramische Grundkörper (1) eine thermische Leitfähigkeit von mehr als 8 W/m·K aufweist.

5. Substrat nach einem der Ansprüche 1 bis 4,
wobei der Hauptbestandteil des keramischen Grundkörpers (1) ausgewählt ist aus einer Gruppe, umfassend ZnO-Bi, ZnO-Pr, Al₂O₃ und AlN.

6. Substrat nach einem der Ansprüche 1 bis 5,
wobei der keramische Grundkörper (1) eine Funktionskeramik enthält, die ausgewählt ist aus einer Gruppe, umfassend Varistorkeramiken, NTC-Keramiken und PTC-Keramiken.

7. Substrat nach einem der Ansprüche 1 bis 6,
wobei der keramische Grundkörper innere Umverdrahtungen (6) und Vias (4) aufweist.

8. Substrat nach einem der Ansprüche 1 bis 7,
wobei die organische Oberflächenstruktur (2) einen thermischen Ausdehnungskoeffizienten aufweist, der dem des keramischen Grundkörpers (1) mit einer Abweichung von maximal ± 1 ppm/K entspricht.

9. Substrat nach einem der Ansprüche 1 bis 8,
wobei der keramische Grundkörper (1) eine Vielzahl von keramischen Schichten umfasst.

10. Substrat nach einem der Ansprüche 1 bis 9,
wobei der keramische Grundkörper (1) ganz oder teilweise in eine organische Leiterplatte (8) eingebettet ist, wobei der thermische Ausdehnungskoeffizient der organischen Leiterplatte (8), dem des keramischen Grundkörpers (1) mit einer Abweichung von maximal ± 1 ppm/K entspricht.

11. Substrat nach Anspruch 10,
wobei der keramische Grundkörper (1) und die organische Leiterplatte (8) an mindestens einer Außenfläche (11) eine organische Oberflächenstruktur (2) mit integrierten äußeren Umverdrahtungen (3) aufweisen.

12. Substrat nach Anspruch 10 oder 11,
wobei der organische Grundkörper (1) und die organische Leiterplatte (8) mittels äußerer Umverdrahtungen (3) und/oder innere Umverdrahtungen (6) leitend miteinander verbunden sind.

13. Substrat nach einem der Ansprüche 1 bis 12,
wobei die äußeren Umverdrahtungen (2) aus einem ersten Metall und die inneren Umverdrahtungen (6) aus einem zweiten Metall bestehen, wobei sich das erste Metall von dem zweiten Metall unterscheidet.

14. Substrat nach einem der Ansprüche 1 bis 13,
wobei das erste Metall und das zweite Metall ausgewählt sind aus einer Gruppe von Metallen, umfassend Kupfer und Silber.

## Claims

1. A substrate,
comprising a ceramic base body (1) and an organic surface structure (2) on at least one first outer surface (9) of the ceramic base body (1), wherein external rewiring structures (3) are integrated into the organic surface structure (2) and wherein the ceramic base body (1) has an integrated overvoltage protection element (7),
wherein a passivation layer (12) is applied at least to the first outer surface (9) of the ceramic base body (1), wherein the passivation layer (12) is located between the first outer surface (9) of the ceramic base body (1) and the organic surface structure (2) and contains as its main component an inorganic material selected from a group comprising SiO₂, AlN, and SiN.

2. The substrate according to claim 1,
wherein the organic surface structure (2) comprises a plurality of organic layers.

3. The substrate according to any one of claims 1 or 2,
wherein the organic layers of the organic surface structure (2) each contain as their main component different organic materials selected from a group comprising photoresists and filled polymers.

4. The substrate according to any one of claims 1 to 3,
wherein the ceramic base body (1) has a thermal conductivity of more than 8 W/m·K.

5. The substrate according to any one of claims 1 to 4,
wherein the main component of the ceramic base body (1) is selected from a group comprising ZnO-Bi, ZnO-Pr, Al₂O₃, and AlN.

6. The substrate according to any one of claims 1 to 5,
wherein the ceramic base body (1) contains a functional ceramic selected from a group comprising varistor ceramics, NTC ceramics, and PTC ceramics.

7. The substrate according to any one of claims 1 to 6,
wherein the ceramic base body has internal rewiring structures (6) and vias (4).

8. The substrate according to any one of claims 1 to 7,
wherein the organic surface structure (2) has a thermal expansion coefficient that corresponds to that of the ceramic base body (1) with a deviation of at most ± 1 ppm/K.

9. The substrate according to any one of claims 1 to 8,
wherein the ceramic base body (1) comprises a plurality of ceramic layers.

10. The substrate according to any one of claims 1 to 9,
wherein the ceramic base body (1) is wholly or partially embedded in an organic printed circuit board (8), wherein the thermal expansion coefficient of the organic printed circuit board (8) corresponds to that of the ceramic base body (1) with a deviation of at most ± 1 ppm/K.

11. The substrate according to claim 10,
wherein the ceramic base body (1) and the organic printed circuit board (8) have an organic surface structure (2) with integrated external rewiring structures (3) on at least one outer surface (11).

12. The substrate according to claim 10 or 11,
wherein the organic base body (1) and the organic circuit board (8) are conductively connected to each other by means of external rewiring structures (3) and/or internal rewiring structures (6).

13. The substrate according to any one of claims 1 to 12,
wherein the external rewiring structures (2) consist of a first metal and the internal rewiring structures (6) consist of a second metal, wherein the first metal differs from the second metal.

14. The substrate according to any one of claims 1 to 13,
wherein the first metal and the second metal are selected from a group of metals comprising copper and silver.

## Revendications

1. Substrat,
comportant un corps de base en céramique (1) et une structure de surface organique (2) sur au moins une première face extérieure (9) du corps de base en céramique (1),
dans laquelle des recâblages externes (3) étant intégrés dans la structure de surface organique (2), et
dans lequel le corps de base en céramique (1) comportant une protection intégrée contre les surtensions (7),
une couche de passivation (12) étant appliquée au moins sur la première face extérieure (9) du corps de base en céramique (1),
dans laquelle la couche de passivation (12) se trouvant entre la première face extérieure (9) du corps de base en céramique (1) et la structure de surface organique (2) et contenant en tant que composant principal un matériau inorganique sélectionné dans un groupe comprenant SiO₂, AlN et SiN.

2. Substrat selon la revendication 1,
dans lequel la structure de surface organique (2) comprend une pluralité de couches organiques.

3. Substrat selon l'une des revendications 1 ou 2,
dans lequel les couches organiques de la structure de surface organique (2) contiennent respectivement différents matériaux organiques comme composant principal, lesquels sont sélectionnés dans un groupe comprenant des photorésists et des polymères chargés.

4. Substrat selon l'une des revendications 1 à 3,
dans lequel le corps de base en céramique (1) présente une conductivité thermique supérieure à 8 W/m·K.

5. Substrat selon l'une des revendications 1 à 4,
dans lequel le composant principal du corps de base en céramique (1) est sélectionné dans un groupe comprenant ZnO-Bi, ZnO-Pr, Al₂O₃ et AlN.

6. Substrat selon l'une des revendications 1 à 5,
dans lequel le corps de base en céramique (1) contient une céramique fonctionnelle sélectionnée dans un groupe comprenant des céramiques de varistance, des céramiques NTC et des céramiques PTC.

7. Substrat selon l'une des revendications 1 à 6,
dans lequel le corps de base en céramique présente des recâblages internes (6) et des vias (4).

8. Substrat selon l'une des revendications 1 à 7,
dans lequel la structure de surface organique (2) présente un coefficient de dilatation thermique qui correspond à celui du corps de base en céramique (1) avec un écart maximal de ± 1 ppm/K.

9. Substrat selon l'une des revendications 1 à 8,
dans lequel le corps de base en céramique (1) comprend une pluralité de couches de céramique.

10. Substrat selon l'une des revendications 1 à 9,
dans lequel le corps de base en céramique (1) est entièrement ou partiellement incorporé dans une carte de circuit imprimé organique (8), le coefficient de dilatation thermique de la carte de circuit imprimé organique (8) correspondant à celui du corps de base en céramique (1) avec un écart maximal de ± 1 ppm/K.

11. Substrat selon la revendication 10,
dans lequel le corps de base en céramique (1) et le circuit imprimé organique (8) présentent sur au moins une face extérieure (11) une structure de surface organique (2) comprenant un recâblage externe intégré (3).

12. Substrat selon la revendication 10 ou 11,
dans lequel le corps de base organique (1) et le circuit imprimé organique (8) sont reliés l'un à l'autre de manière conductrice au moyen de recâblages externes (3) et/ou de recâblages internes (6).

13. Substrat selon l'une des revendications 1 à 12,
dans lequel les recâblages externes (2) sont constitués d'un premier métal et les recâblages internes (6) d'un second métal, le premier métal étant différent du second métal.

14. Substrat selon l'une des revendications 1 à 13,
dans lequel le premier métal et le second métal sont choisis dans un groupe de métaux comprenant le cuivre et l'argent.
